**Europäisches Patentamt**

**European Patent Office**

**Office européen des brevets**

(19)

(11) Publication number: **0 018 767**
**B1**

(12)                    **EUROPEAN PATENT SPECIFICATION**

(45) Date of publication of patent specification: **18.05.83**

(51) Int. Cl.³: **H 03 F 3/45, H 03 F 3/345**

(21) Application number: **80301298.8**

(22) Date of filing: **23.04.80**

(54) **Differential amplifier.**

(30) Priority: **01.05.79 US 35039**
**01.05.79 US 35040**

(43) Date of publication of application:
**12.11.80 Bulletin 80/23**

(45) Publication of the grant of the patent:
**18.05.83 Bulletin 83/20**

(84) Designated Contracting States:
**DE FR GB**

(56) References cited:
**US - A - 3 970 950**
**US - A - 4 010 425**

**IBM TECHNICAL DISCLOSURE BULLETIN, vol.
21, no. 4, September 1978, pages 1590—1592
New York, U.S.A.
C.R. HOFFMAN: "Common-Mode Translator for
a Differential Signal Using MOSFET
Technology" Page 1591**

(73) Proprietor: **MOTOROLA, INC.**
**1303 East Algonquin Road**
**Schaumburg Illinois 60196 (US)**

(72) Inventor: **Eckert, Kim Hunter**
**10401 Walnut Bend**
**Austin Texas 78753 (US)**

(74) Representative: **Newens, Leonard Eric et al,
F.J. CLEVELAND & COMPANY 40/43 Chancery
Lane
London WC2A 1JQ (GB)**

Courier Press, Leamington Spa, England.

Differential amplifier

Background of the Invention
*Field of the Invention*
This invention relates generally to differential amplifiers, and more particularly to a metal-oxide-semiconductor (MOS) differential amplifier exhibiting high differential gain over a wide common mode range.

*Description of the Prior Art*
The advantages offered by NMOS technology are well known; e.g. higher density, greater yield, etc. Thus, smaller NMOS device geometries permit a greater number of devices to be produced per unit area or, stated another way, a single NMOS device will occupy less space. This characteristic is extremely important in the design and fabrication of complex digital integrated circuits; for example, single chip microprocessors.

Whereas digital circuitry is generally characterized by its "ON/OFF" or "ONE/ZERO" nature, most measurements in the real world are inherently analog; e.g., temperature, pressure, speed, voltage, etc. Therefore, it is necessary that microprocessors and other digital circuitry communicate or interface with analog circuitry such as amplifiers, buffers, comparators, etc., in order to permit digital processing of the analog signals. The required interfacing may be accomplished by providing analog components which are external to the microprocessor chip. However, such arrangements generally require more current, a larger power supply and commonly present more opportunities for design and manufacturing errors. To avoid these disadvantages, complex analog circuits such as differential amplifiers and voltage crossover detectors are being manufactured integrally with the digital circuitry; e.g., on the microprocessor chip itself, and due to the complex nature of microprocessors, the inclusion of analog devices on the same chip requires that the same manufacturing process be employed. Thus, a differential amplifier or voltage crossover detector included on an NMOS microprocessor chip must be fabricated in accordance with NMOS processing techniques, and their design must be tailored to such processing techniques.

Previous MOS implementations of differential amplifiers have been very similar functionally to bipolar implementations. That is, both employ a current source, level shifters, integrator output buffers, etc. Furthermore, the prior art devices generally require an input stage having a high differential gain and a low common mode gain since each additional stage amplifies the common mode signal; i.e., errors produced in the first stage are further amplified in subsequent stages. Thus, the device is complex, requires a large number of components and is both costly and more difficult to fabricate. In addition, the use of enhancement devices at the inputs limits the maximum swing of the amplifier since these devices will turn off if the input becomes too low.

A detailed discussion of such prior art differential amplifiers can be found in the "IEEE Spectrum," February, 1979; pages 24—32 and in the "IEEE-Journal of Solid State Circuits"; December, 1978, pages 760—766.

U.S. Patent No. 3,970,950 describes a dual channel, high gain differential amplifier utilizing enhancement-depletion MOS field effect transistors which exhibit high common mode rejection and fast switching characteristics. However, there is no provision for additional stages of amplification which do not substantially increase the common mode gain.

Summary of the Invention
It is an object of the present invention to provide a differential amplifier having large differential gain over a wide common mode range.

It is a further object of the invention to provide an MOS differential amplifier having a common mode gain which is not substantially increased by additional stages of amplification.

It is a still further object of the invention to provide an MOS differential amplifier having an improved input voltage swing.

These objects are achieved, in part, by using depletion devices as input loads and coupling the load gates to the amplifier input to balance their switching point over the common mode range.

According to one aspect of the invention there is provided a differential amplifier circuit for receiving first and second potentials comprising: an input stage for receiving said first and second potentials and amplifying the difference therebetween; and at least one additional amplifying stage coupled to said input stage for amplifying said difference, said at least one additional amplifying stage having a first input coupled to one of said first and second potentials for reducing common mode gain.

According to another aspect of the invention there is provided a differential amplifier circuit for amplifying the difference between first and second input voltages, said circuit including an input stage coupled to said first and second voltages for amplifying the difference therebetween, characterized in that there is provided a plurality of amplifying stages coupled in sequence each including first and second MOS devices, said first device having a gate coupled to one of said first and second voltages and said second device having a gate coupled to the output of the previous stage.

According to a further aspect of the invention there is provided a NMOS differential amplifier for amplifying the difference between first and second input voltages, comprising: an input stage comprised of NMOS devices for receiving said first and second voltages and amplifying the difference therebetween, characterised in that there is provided at least one additional amplifying stage coupled to the output of said input stage, said additional amplifier stage including a depletion device having a gate coupled to one of said first and second input voltages.

The above and other objects, features and advantages of the invention will be better understood from the following detailed description taken in conjunction with the accompanying drawings, in which:

Figure 1 is a schematic diagram of the inventive differential amplifier circuit;

Figure 2 illustrates in graphical form the differential gain of the inventive circuit as a function of the input voltage;

Description of the Preferred Embodiment

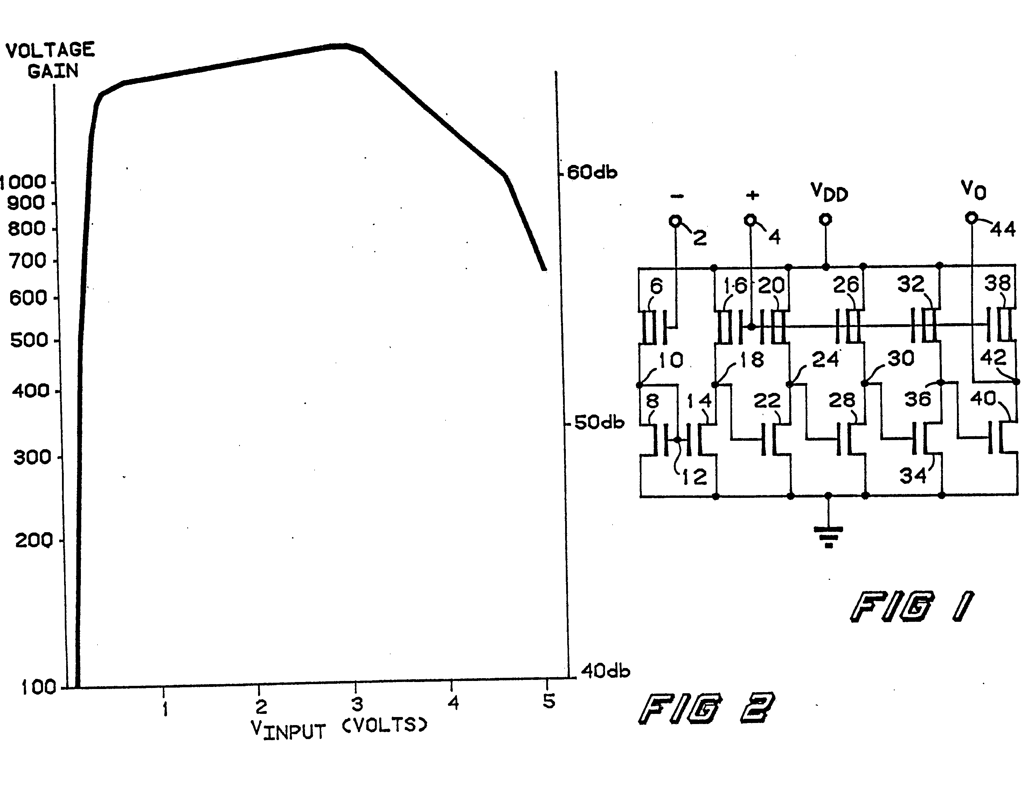

Figure 1 is a schematic diagram of the inventive differential amplifier circuit. While N-channel MOS devices are preferred, it should be clear that other processing techniques (E.G. P-channel, CMOS) could be used to implement the circuit.

Referring to Figure 1, the amplifier is comprised of a first leg including depletion device 6 and enhancement device 8 and a second leg including depletion load device 16 and enhancement device 14. Each of these legs are coupled between a source of supply voltage $V_{DD}$ and ground as are the additional stages to be discussed hereinbelow. The gate of depletion device 6 is coupled to a negative input voltage terminal 2, and the gate of depletion device 16 is coupled to a positive input voltage terminal 4. The junction of the source of device 6 and the drain of device 8 (node 10) is coupled to the gates of enhancement devices 8 and 14 at node 12.

The circuit includes four additional stages each comprised of a depletion load device in series with an enhancement device coupled between $V_{DD}$ and ground. The depletion devices have a resistance which is greater than that of the enhancement devices. The gate of each depletion load device in each stage is coupled to the gate of device 16, and the gate of each enhancement device is coupled to the drain of the enhancement device of the previous stage. Thus, the first additional stage is comprised of depletion device 20 and enhancement device 22, the second additional stage is comprised of depletion device 26 and enhancement device 28, the third additional stage includes depletion device 32 and enhancement device 34 and the final or fifth stage comprises depletion device 38 and enhancement device 40. The gates of devices 20, 26, 32 and 38 are all coupled to the gate of device 16, and the gates of devices 22, 28, 34 and 40 are coupled to node 18, 24, 30 and 36 respectively. The output voltage Vo is available at node 42 and output terminal 44. It should be clear that if terminals 2 and 4 were coupled to a reference voltage and to an AC signal respectively, the output appearing at terminal 44 would be indicative of the crossover points of the AC signal and said reference voltage.

As in the case of prior art differential amplifiers it is desirable to increase the ratio of differential gain to common mode gain. This is accomplished with the present inventive circuit because only the differential signal is amplified in subsequent stages while the common mode signal remains substantially constant. To illustrate this, assume that terminals 2 and 4 are coupled together rendering the gate potentials of devices 6 and 16 equal. The current through the first leg (devices 6 and 8) is dependent only on the voltage at terminal 2 and the voltage at node 10 is a function of that current. Since node 10 is coupled to the gates of devices 8 and 14 at node 12, and since the voltages at the gates of devices 6 and 16 are equal, the voltage at node 18 is substantially equal to the voltage at node 10 (approximately one enhancement threshold voltage above ground) if devices 6 and 16 are substantially identical and devices 8 and 14 are substantially identical. Thus, there is substantially no common-mode amplification. Referring now to the second stage, the same voltage is applied to the gate of device 20 as is applied to the gate of device 16, and the same voltage is applied to the gate of device 22 as is applied to the gate of device 14. Thus, the voltage at node 24 is substantially equal to the voltage at node 18. Using the same analysis, the voltages at nodes 30, 36 and 42 are equal to the voltage at nodes 10, 18 and 24 if devices 6, 16, 20, 26, 32 and 38 are identical and if devices 8, 14, 22, 28, 34 and 40 are identical. Thus, theoretically there is no amplification of the common mode signal in the additional stages.

Suitable results are obtained if the depletion devices used have a width of eight microns and a length of eight microns. With these geometries, the output voltage was found to vary a length of eight microns. With these geometries, the output voltage was found to vary about 10 mv over the entire range of input voltages.

To illustrate the differential gain behavior of the circuit, assume that the voltage at terminal 4 remains constant and the voltage on terminal 2 approaches $V_{DD}$. This will cause the current through depletion device 6 to increase thus increasing the voltage at nodes 10 and 12, which voltage is applied to the gates of devices 8 and 14. The increased drive to device 14 causes it to conduct more current. Since the voltage at the gate of device 16 remains the same, the voltage at node 18 will decrease reducing the drive to device 22. Since, however, the drive to device 20 is unchanged, the voltage at node 24 increases. Using the same analysis, the voltage at node 30 decreases, the voltage at node 36 increases and the voltage at node 42 decreases. Since each stage of the amplifier imparts a differential gain of approximately five on the input signal with negligible common mode gain, the differential signal is substantially amplified at Vo.

Figure 2 is a graphical representation of the voltage gain as a function of input voltage. It can be seen that over a common mode range of approximately 0.2 to 4.5 volts, a gain in excess of 60db is achieved.

For the sake of completeness, the following indicates suitable lengths and widths of the various MOS devices illustrated in Figure 1.

| Element | Width/Length (Microns) |
|---|---|
| 6, 16, 20, 26, 32, 38 | 8/20 |
| 8, 14, 22, 28, 34, 40 | 130/8 |

The foregoing description of the embodiment of the invention is by way of example only and is not intended to limit the scope of the appended claims. No attempt has been made to illustrate all possible embodiments of the invention but rather only to illustrate its principles in the best manner presently known to practice them. For example, the circuit may be implemented in NMOS, PMOS, CMOS, etc. The use of depletion type load devices serves to increase the overall input voltage swing. If this were not a critical requirement, enhancement devices could be employed. Further, the beneficial characteristics of the circuit will be achieved if the gates of the depletion devices in each additional stage are coupled to the positive or negative input.

**Claims**

1. A differential amplifier circuit for receiving first and second potentials (4 and 2), the circuit including an input stage (6, 8, 14, 16) for receiving said first and second potentials and amplifying the difference therebetween characterized in that there is provided at least one additional amplifying stage (20, 22) coupled to said input stage for amplifying said difference, said at least one additional amplifying stage having a first input coupled to one of said first and second potentials for reducing common mode gain.

2. A circuit according to claim 1 wherein said circuit includes a plurality of additional amplifying stages coupled in sequence wherein each has a first input coupled to one of said first and second potentials and a second input coupled to an output of a previous one of said amplifying stages.

3. A circuit according to claim 2 wherein each of said additional amplifier stages comprises first and second series connected MOS devices, said first device having a gate coupled to said first potential and said second device having a gate coupled to the output of a previous one of said amplifying stages.

4. A circuit according to claim 3 wherein said input stage comprises first and second pairs of series connected MOS devices (6, 8 and 14, 16) each pair coupled across a source of supply voltage and ground, said first potential coupled to one of said devices in said second pair and said second potential coupled to one of said devices in said first pair.

5. A circuit according to claim 4 wherein said first pair of devices comprises:

a depletion device (6) having a gate coupled to said second potential; and

a first enhancement device (8) whose drain is coupled to its gate.

6. A circuit according to claim 5 wherein said second pair of devices comprises:

a depletion device (16) having a gate coupled to said first potential; and

an enhancement device (14) having a gate coupled to the gate of said first enhancement device.

7. A circuit according to claim 6 wherein said first device in each of said plurality of additional stages is a depletion device and wherein said second device in each of said plurality of additional stages is an enhancement device.

8. A circuit according to claim 7 wherein the enhancement devices in each of said plurality of additional stages and in each of said first and second pairs are substantially identical and wherein the depletion devices in each of said plurality of additional stages and in said first and second pairs are substantially identical.

9. A circuit according to claim 8 wherein the resistance of the depletion devices is greater than that of the enhancement devices.

10. A circuit according to claim 9 wherein said MOS devices are N-channel MOS devices.

11. A differential amplifier circuit for amplifying the difference between first and second input voltages, said circuit including an input stage (6, 8, 14, 16) coupled to said first and second voltages for amplifying the difference therebetween, characterized in that there is provided a plurality of amplifying stages coupled in sequence each including first (20, 26, 32, 38) and second (22, 28, 34, 40) MOS devices, said first device having a gate coupled to one of said first and second voltages and said second device having a gate coupled to the output of the previous stage.

12. A circuit according to claim 11 wherein said first device is a depletion device and said second device is an enhancement device.

13. A differential NMOS amplifier for amplifying the difference between first and second input voltages (2 and 4), comprising

an input stage (6, 8, 14, 16) comprised of NMOS devices for receiving said first and second voltages and amplifying the difference therebetween; characterised in that there is provided at least one additional amplifying stage coupled to the output of said input stage, said additional amplifier stage including a depletion device (20) having a gate coupled to said first input voltage (4).

14. A circuit according to claim 11 wherein said first input voltage is a reference voltage and said second input voltage is an AC signal, said circuit having an output (44) indicative of the crossover points of said AC signal and said reference voltage.

## Revendications

1. Circuit d'amplificateur différentiel destiné à recevoir des premier et second potentiels (4 et 2), le circuit comprenant un étage d'entrée (6, 8, 14, 16) pour recevoir lesdits premier et second potentiels et amplifier la différence entre eux, caractérisé en ce qu'il est prévu au moins un étage d'amplification supplémentaire (20, 22) couplé avec ledit étage d'entrée pour amplifier ladite différence, ledit au moins un étage d'amplification supplémentaire ayant une première entrée couplée à l'un desdits premier et second potentiels pour réduire le gain en mode commun.

2. Circuit selon la revendication 1, dans lequel ledit circuit comporte plusieurs étages d'amplification supplémentaire couplés en séquence, ayant chacun une première entrée couplée à l'un desdits premier et second potentiels et une seconde entrée couplée à une sortie de l'un précédent desdits étages d'amplification.

3. Circuit selon la revendication 2, dans lequel chacun desdits étages d'amplificateur supplémentaire comporte des premier et second composants MOS connectés en série, ledit premier composant ayant une grille couplée avec ledit premier potentiel et ledit second composant ayant une grille couplée avec la sortie de l'un précédent desdits étages d'amplification.

4. Circuit selon la revendication 3, dans lequel ledit étage d'entrée comporte des première et seconde paires de composants MOS connectés en série (6, 8 et 14, 16), chaque paire couplée entre une source de tension d'alimentation et la masse, ledit premier potentiel étant couplé avec l'un desdits composants de ladite seconde paire et ledit second potentiel étant couplé avec l'un desdits composants de ladite première paire.

5. Circuit selon la revendication 4, dans lequel ladite première paire de composants comporte un composant appauvri (6) ayant une grille couplée avec ledit second potentiel et un premier composant enrichi (8) dont le drain est couplé avec sa grille.

6. Circuit selon la revendication 5, dans lequel ladite seconde paire de composants comporte un composant appauvri (16) ayant une grille couplée avec ledit premier potentiel et un composant enrichi (14) ayant une grille couplée avec la grille dudit premier composant enrichi.

7. Circuit selon la revendication 6, dans lequel ledit premier composant dans chacun desdits plusieurs étages supplémentaires est un composant appauvri et dans lequel ledit second composant dans chacun desdits plusieurs étages supplémentaires est un composant enrichi.

8. Circuit selon la revendication 7, dans lequel les composants enrichis de chacun desdits plusieurs étages supplémentaires et dans chacune desdites première et seconde paires sont pratiquement identiques et dans lequel les composants appauvris dans chacun desdits plusieurs étages supplémentaires et dans chacune desdites première et seconde paires sont pratiquement identiques.

9. Circuit selon la revendication 8, dans lequel la résistance des composants appauvris est supérieure à celle des composants enrichis.

10. Circuit selon la revendication 9, caractérisé en ce que lesdits composants MOS sont des composants MOS à canal N.

11. Circuit d'amplificateur différentiel destiné à amplifier la différence entre les première et seconde tensions d'entrée, ledit circuit comprenant un étage d'entrée fixe (6, 8, 14, 16) couplé avec lesdites première et seconde tensions pour amplifier la différence entre elles, caractérisé en ce qu'il est prévu plusieurs étages d'amplification couplée en séquence, comprenant chacun des premiers (20, 26, 32, 38) et seconds (22, 28, 34, 40) composants MOS, ledit premier composant ayant une grille couplée avec l'une desdites première et seconde tensions et ledit second composant ayant une grille couplée avec la sortie de l'étage précédent.

12. Circuit selon la revendication 11, dans lequel ledit premier composant est un composant appauvri et ledit second composant est un composant enrichi.

13. Amplificateur différentiel NMOS destiné à amplifier la différence entre des première et seconde tensions d'entrée (2 et 4), comprenant un étage d'entrée (6, 8, 14, 16) constitué par des composants NMOS pour recevoir lesdites première et seconde tensions et amplifier la différence entre elles, caractérisé en ce qu'il est prévu au moins un étage d'amplification supplémentaire couplé avec la sortie dudit étage d'entrée, ledit étage d'amplification supplémentaire comprenant un composant appauvri (20) dont une grille est couplée avec ladite première tension d'entrée (4).

14. Circuit selon la revendication 11, dans lequel ladite première tension d'entrée est une tension de référence et ladite seconde tension d'entrée est un signal alternatif, ledit circuit ayant une sortie (44) indiquant les points de croisement dudit signal alternatif et de ladite tension de référence.

## Patentansprüche

1. Eine Differentialverstärkerschaltung zum Empfangen eines ersten und eines zweiten Potentials (4 und 2), wobei die Schaltung eine Eingangsstufe (6, 8, 14, 16) zum Empfangen des ersten und zweiten Potentials und zum Verstärken der Differenz zwischen den Potentialen aufweist, dadurch gekennzeichnet, daß wenigstens eine zusätzliche verstärkende Stufe (20, 22) vorgesehen ist, die an die Eingangsstufe zum Verstärken der Differenz angeschlossen ist, wobei die wenigstens eine zusätzliche verstärkende Stufe einen ersten Eingang hat, der an eines der ersten und zweiten Potentiale angeschlossen ist, um den Gleichtaktgewinn zu reduzieren.

2. Eine Schaltung nach Anspruch 1, bei der die Schaltung eine Vielzahl von zusätzlichen verstärkenden Stufen aufweist, die in Reihenschaltung geschaltet sind, wobei jede einen ersten Eingang hat, der an eines der ersten und zweiten Potentiale angeschlossen ist, und einen zweiten Eingang hat, der an einen Ausgang einer vorhergehenden der verstärkenden Stufen angeschlossen ist.

3. Eine Schaltung nach Anspruch 2, bei der jede der zusätzlichen Verstärkerstufen folgende Merkmale hat: erste und zweite in Reihe geschaltete MOS-Geräte, wobei das erste Gerät ein Gatter aufweist, das an das erste Potential angeschlossen ist, und wobei das zweite Gerät ein Gatter hat, das an den Ausgang einer vorhergehenden der verstärkenden Stufen angeschlossen ist.

4. Eine Schaltung nach Anspruch 3, in der die Eingangsstufe ein erstes und ein zweites Paar von in Reihe geschalteten MOS-Geräten (6, 8 und 14, 16) hat, wobei jedes Paar zwischen einer Versorgungsspannungsquelle und Masse angeschlossen ist, wobei das erste Potential an eins der Geräte in dem zweiten Paar und das zweite Potential an eins der Geräte in dem ersten Paar angeschlossen ist.

5. Eine Schaltung nach Anspruch 4, in der das erste Paar der Geräte folgende Merkmale aufweist:

Ein Entleerungs-Gerät (6) mit einem Gatter, das an dem zweiten Potential angeschlossen ist; und

einem ersten Anreicherungs-Gerät (8), dessen Drain an seinen Gatter angeschlossen ist. ist.

6. Eine Schaltung nach Anspruch 5, in der das zweite Paar der Geräte folgende Merkmale hat:

Ein Entleerungs-Gerät (16) mit einem Gatter, das an dem ersten Potential angeschlossen ist; und

einem Anreicherungs-Gerät (14) mit einem Gatter, das mit dem Gatter des ersten Anreicherungs-Gerätes verbunden ist.

7. Eine Schaltung nach Anspruch 6, in der das erste Gerät in jeder der Vielzahl von zusätzlichen Stufen ein Entleerungs-Gerät ist und in der das zweite Gerät in jeder der Vielzahl von zusätzlichen Stufen ein Anreicherungs-Gerät ist.

8. Eine Schaltung nach Anspruch 7, in der die Anreicherungs-Geräte in jeder der Vielzahl von zusätzlichen Stufen und in jedem des ersten und zweiten Paares im wesentlichen identisch sind und in dem die Entleerungs-Geräte in jeder der Vielzahl von zusätzlichen Stufen und in jedem des ersten und zweiten Paares im wesentlichen identisch sind.

9. Eine Schaltung nach Anspruch 8, in der der Widerstand der Entleerungs-Geräte größer ist als der der Anreicherungs-Geräte.

10. Eine Schaltung nach Anspruch 9, in der die MOS-Geräte N-Kanal-MOS-Geräte sind.

11. Eine Differentialverstärkerschaltung zum Verstärken der Differenz zwischen einer ersten und einer zweiten Eingangsspannung, wobei die Schaltung eine Eingangsstufe (6, 8, 14, 16) aufweist, die an die erste und zweite Spannung zum Verstärken der Differenz zwischen den Spannungen angeschlossen ist, dadurch gekennzeichnet, daß eine Vielzahl von in Reihe geschalteten verstärkenden Stufen vorgesehen ist, die jeweils erste (20, 26, 32, 38) und zweite (22, 28, 34, 40) MOS-Geräte enthalten, wobei das erste Gerät ein Gatter hat, das an eine der ersten und zweiten Spannungen angeschlossen ist, und wobei das zweite Gerät ein Gatter hat, das an den Ausgang der vorhergehenden Stufe angeschlossen ist.

12. Eine Schaltung nach Anspruch 11, in der das erste Gerät ein Entleerungs-Gerät und das zweite Gerät ein Anreicherungs-Gerät ist.

13. Ein NMOS-Differentialverstärker zum Verstärken der Differenz zwischen der ersten und der zweiten Eingangsspannung (2 und 4), mit einer Eingangsstufe (6, 8, 14, 16), die aus NMOS-Geräten zum Empfangen der ersten und zweiten Spannungen und zum Verstärken der Differenz zwischen den Spannungen besteht, dadurch gekennzeichnet, daß wenigstens eine zusätzliche Verstärkungsstufe vorgesehen ist, die an den Ausgang der Eingangsstufe angeschlossen ist, wobei die zusätzliche Verstärkerstufe ein Entleerungs-Gerät (20) hat, das eine Gatter aufweist, das an die erste Eingangsspannung (4) angeschlossen ist.

14. Eine Schaltung nach Anspruch 11, in der die erste Eingangsspannung eine Bezugsspannung ist und in der die zweite Eingangsspannung ein Wechselstromsignal ist, wobei die Schaltung einen Ausgang (44) hat, der die Kreuzungspunkte des Wechselstrom-Signals und der Bezugsspannung anzeigt.

VOLTAGE GAIN

1000
900
800
700
600
500
400
300
200
100

− 60db

− 50db

− 40db

$V_{INPUT}$ (VOLTS)

1  2  3  4  5

FIG 2

− + $V_{DD}$ $V_O$

2  4  44

6  16 20  26  32  38

10  18  24  30  42

8 14  22  28  36  40

12  34

0018767

FIG 1